## Europäisches Patentamt
## European Patent Office
## Office européen des brevets

(19)

(11) Publication number: **0 174 712**
A2

(12)

# EUROPEAN PATENT APPLICATION

(21) Application number: 85303734.9

(22) Date of filing: 28.05.85

(51) Int. Cl.⁴: **H 01 L 29/80**
G 01 N 27/00, H 01 L 21/74

(30) Priority: 01.06.84 GB 8414036

(43) Date of publication of application:
19.03.86 Bulletin 86/12

(84) Designated Contracting States:
AT BE CH DE FR GB IT LI LU NL SE

(71) Applicant: EMI Limited
Blyth Road
Hayes Middlesex, UB3 1BP(GB)

(72) Inventor: Kember, Peter Nicholas
39, Haslemere Avenue
Ealing London, W13 9UH(GB)

(72) Inventor: Nashashibi, Tawfic Saeb
1, Manor Leaze
Egham Surrey TW20 ANJ(GB)

(74) Representative: Marsh, Robin Geoffrey
Thorn EMI Patents Limited The Quadrangle Westmount
Centre Uxbridge Road
Hayes Middlesex, UB4 0HB(GB)

(54) Semiconductor devices having electrically conductive paths.

(57) A semiconductor device (eg. ISFET) has electrically conductive paths (21, 31) extending from the drain and source regions (11, 12) to a remote surface (16) of the device. Each path is formed either as a metallisation on the wall of a channel extending from the vicinity of the drain or source region to the remote surface or as a diffusion of a suitable dopant.

EP 0 174 712 A2

: 1 :

IMPROVEMENTS RELATING TO SEMICONDUCTOR DEVICES

This invention relates to a semiconductor device and it relates especially, although not exclusively, to a field effect device, eg. an ion sensitive field effect transistor (ISFET).

An ISFET comprises typically a substrate of a semiconductor material of one polarity type provided with drain and source regions of the opposite polarity type and an active gate region including an ion sensitive membrane which is exposed, in use, to an electrolyte solution. Since the electrolyte solution presents a hostile environment to the substrate material, selected surfaces thereof are generally encapsulated in a suitable protective material. Electrical leads and contacts which are usually attached to the drain and source region at the top surface of the device tend to render encapsulation time consuming and difficult.

It is an object of this invention to provide an electrical device wherein this problem is at least alleviated.

Accordingly there is provided an electrical device comprising a body of a semiconductive material having an electrically conductive path which extends from a region within the body to a remote surface thereof at which an electrical connection can be established, the electrically conductive path being formed in or on a wall of a channel extending from the vicinity of said region to said remote surface.

The device may be a field effect device. In the case of

0174712

an ISFET, because ohmic connections are established within the body of the device encapsulation thereof is simplified considerably.

In an embodiment respective electrically conductive paths extend from the drain region and the source region to a surface of the device remote from the gate region thereof; these paths may be of a semi-conductor material of the same polarity type as the material forming the drain and source regions and may be formed in the walls of respective channels extending from the drain and source regions to said remote surface. Alternatively the electrically conductive paths may comprise metallisations on the walls of respective channels extending from the drain and source regions to said remote surface.

In accordance with another aspect of the invention there is provided a method of establising an ohmic connection of a region within a body of semiconductive material to a remote surface thereof, the method including the steps of providing a body of semiconductive material, forming in the body a channel extending from the vicinity of said region to said remote surface, and treating the wall of said channel to establish an electrically conductive path in or on said wall.

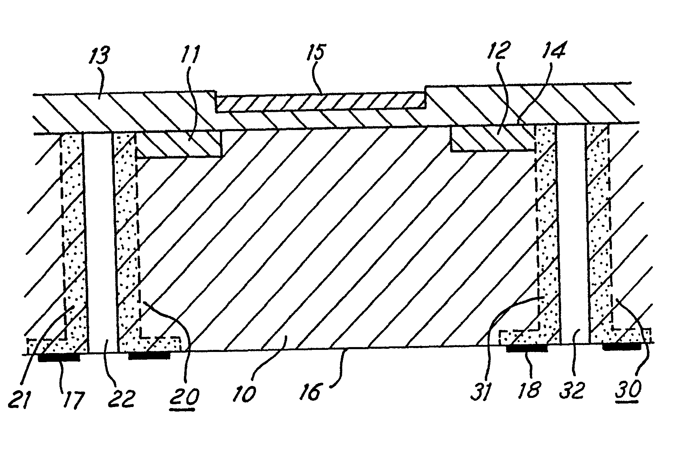

In order that the invention may be carried readily into effect an embodiment thereof is now described by reference to the only drawing which shows a cross-sectional view through an ISFET.

Referring to the drawing, an ion sensitive field effect transistor (ISFET) comprises a substrate 10 of a p-type semiconductor material (e.g. silicon) and respective drain and source regions, 11 and 12, of an n-type semiconductor material (e.g. silicon doped with phosphorous). A layer 13 of an electrically insulating material (e.g. silicon nitride or silicon oxide) deposited on the top surface 14 of the substrate carries an ion sensitive membrane 15 adjacent the active gate region of the device between the drain and source regions.

Ohmic connections to the drain and source regions are established within the body of the device and to this end respective electrically conductive paths 20, 30 extend from the drain and source regions to the back surface 16 of the device, remote from the gate region.   Electrical contacts 17, 18 to which respective leads may be attached, are provided on the back surface.

In one example, the electrically conductive paths 20, 30 comprise regions 21, 31 of an n type semiconductor material formed in the walls of respective channels 22, 32.   The conductive regions 21, 31 are formed by diffusing a suitable n-type dopant-phosphorus in this example – into the channel walls.

A suitable fabrication technique is now described, by way of example only.

Initially channels 22, 32 interconnecting the major surfaces of a silicon wafer are produced in the $\langle 100 \rangle$ direction by an etch process.   A film of silicon nitride or silicon oxide, typically at least $\frac{1}{2}\mu$m thick, may be used as a mask and suitable etchants include a 33% aqueous solution of potassium hydroxide (KOH) which, at $80^\circ$C $\pm$ $3^\circ$C, has an etch rate of $72\mu$m/hr and the so called EDP etchant consisting of 390 cm$^3$ 1, 2 diaminoethane, 110 cm$^3$ water and 55 g pyrocatechol (or different quantities in the same proportions) which at $116^\circ$C ($\pm$ $2^\circ$C) has an etch rate of 35 $\mu$m/hr.

The drain and source regions 11 and 12, of the device are located close to the channels using fabrication techniques well known in the art, and electrically conductive regions 21, 31 are then developed in the channel walls, by a diffusion process, thereby to establish ohmic connections to the drain and source regions.   The diffusion process is in two stages;   first, nitrogen gas which has been bubbled through an aqueous solution of phosphorus oxychloride is passed over the substrate for several hours in a furnace tube at $1050^\circ$C.   The gas penetrates channels 22, 32 and a deposit of phosphorus collects on the channel walls.   The phosphorus is then "driven" into the walls by passing pure nitrogen over the substrate for a further period of about two hours at 1000°C. The level of doping achieved influences the series resistance in the drain source circuit of the device. In practice it has been found that in the case of a silicon substrate having a resistivity of 5Ωcm and provided with channels 100μm in diameter a series resistance as low as 30Ω can be achieved.

Electrical contacts 17 and 18 may then be deposited on the back surface of substrate 10 by evaporation of a suitable metal e.g. aluminium, preferably at grazing incidence so as to prevent metal being deposited on the walls of the channels. If desired the contacts may be patterned using known photolithographic techniques.

The electrically conductive paths 20, 30 need not necessarily be of a semiconductor material. In an alternative example the channels may comprise metallisation layers deposited by evaporation on the channels walls.

It will be appreciated that the present invention is particularly advantageous in the case of an ISFET; a construction wherein ohmic connections to the drain and source regions are established within the body of the device obviates the need for electrical contacts on the top surface thereof and so simplifies encapsulation of the device. It will be understood, however, that the present invention encompasses other forms of semiconductor device, particularly field effect devices and devices intended for use in applications wherein electrical connection to the back surface of the device may be desirable.

It will be appreciated that the word "ohmic" used throughout this specification signifies a resistance sufficiently low to be useful in the formation of electrical connections in a semiconductor device.

## CLAIMS

1. An electrical device comprises a body of a semiconductive material having an electrically conductive path which extends from a region within the body to a remote surface thereof at which an electrical connection can be established, the electrically conductive path being formed in or on a wall of a channel extending from the vicinity of said region to said remote surface.

2. An electrical device according to Claim 1 wherein said electrically conductive path comprises a diffusion of a dopant formed in the channel wall.

3. An electrical device according to Claim 1 wherein said electrically conductive path comprises a metallisation formed on the channel wall.

4. An electrical device according to any one of Claims 1 to 3 in the form of a field effect device wherein respective said electrically conductive paths extend from the drain region and the source region to said remote surface.

5. An electrical device according to Claim 4 in the form of an ion sensitive field effect transistor.

6. An electrical device according to any one of Claims 1 to 5 comprising an electrically conductive contact on said remote surface connected to a said electrically conductive path.

7. A method of establising an ohmic connection of a region within a body of semiconductive material to a remote surface thereof, the method including the steps of providing a body of semiconductive material, forming in the body a channel extending from the vicinity of said region to said remote surface, and treating the wall of said channel to establish an electrically conductive path in or on said wall.

8. A method according to Claim 7 including causing a dopant to diffuse into the channel wall thereby to establish said electrically conductive path.

9. A method according to Claim 7 including depositing a metallisation layer on the channel wall.